# EUROPEAN PATENT SPECIFICATION

(11) **EP 1 900 034 B1**
(45) Date of publication and mention of the grant of the patent: **10.08.2011**
(21) Application number: 06765787.4
(22) Date of filing: 20.06.2006
(51) Int. Cl.: H01L 29/732, H01L 21/331

(54) **Bipolar transistor and method of manufacturing the same**
Bipolartransistor und Herstellungsverfahren dafür
Transistor bipolaire et son procédé de fabrication

(30) Priority: 27.06.2005 EP 05105716
(43) Date of publication of application: 19.03.2008
(73) Proprietor: NXP B.V., 5656 AG Eindhoven (NL)
(72) Inventor: HIJZEN, Erwin, NL-5656 AA Eindhoven (NL); MELAI, Joost, NL-5656 AA Eindhoven (NL); NEUILLY, Francois, NL-5656 AA Eindhoven (NL)
(74) Representative: Williamson, Paul Lewis
(86) International application number: PCT/IB2006/051975
(87) International publication number: WO 2007/000683

(56) References cited:
- US-A- 5 656 514
- US-A1- 2005 121 748
- US-B1- 6 329 698
- US-B1- 6 440 810

## Description

The invention relates to a semiconductor device with a substrate and a semiconductor body comprising a bipolar transistor with an emitter region of a first conductivity type, a base region of a second conductivity type opposite to the first conductivity type and a collector region of said first conductivity type, which emitter region comprises a mesa-shaped emitter connection region provided with a spacer and adjacent thereto a base connection region comprising a conductive region of polycrystalline silicon. Such a transistor is highly desirable for forming RF (=Radio Frequency) circuits. The invention also relates to a method of manufacturing such a device.

Such a device and method are known from US patent US-B-6,440,810. Said document describes a semiconductor device with a bipolar transistor comprising an emitter region having a mesa-shaped emitter connection region, around which a spacer is formed, with a base connection region comprising a conductive region of polycrystalline silicon positioned adjacent to the spacer. The emitter of the transistor is formed by making an opening in a layer structure comprising a conductive layer of polycrystalline silicon, providing the walls and an adjacent part of the bottom of the opening with a spacer and forming an emitter connection region therein, likewise of polycrystalline silicon. The actual emitter region is formed in an underlying part of the semiconductor body, which is of a conductivity type opposite to that of a dopant comprised therein, through outdiffusion of atoms of said dopant. In order to prevent the part of the semiconductor body that is present under the opening in the polycrystalline layer from being affected and/or roughened upon etching of said opening, an oxide layer functioning as an etch stop is provided between the polycrystalline silicon layer and the underlying part of the semiconductor body. Etching of the polycrystalline layer can be stopped when the oxide layer is reached, and the oxide layer within the opening can easily and selectively be removed again. Outside the emitter connection region, the thin oxide layer can be removed again by means of a suitable heat treatment, with the undesirable electrically insulating nature of said layer being eliminated at least by breaking up said layer.

A drawback of the known transistor is that it is difficult to manufacture, because the thin insulating layer must be very thin, because otherwise it cannot easily be broken up again by means of a heat treatment. Breaking up a thicker oxide layer requires a heat treatment at a temperature such that the doping profiles of the transistor will move as a result of thermal diffusion. This conflicts with the object of obtaining a transistor that possesses very good RF (=Radio Frequency) properties, because such a transistor must have very small lateral dimensions. This applies as regards the transistor itself, but also as regards its subregions, in particular as regards the doping profiles thereof. The local provision of a thicker insulating layer, i.e. approximately at the location of the emitter connection region that is to be formed, does not help in this regard. A heat treatment for breaking up the insulating layer is no longer necessary, to be true, because the insulating layer is accessible for (locally) removing the same where this is necessary, but the local provision of such a layer makes it necessary to use alignment tolerances, as a result of which the minimum dimensions of the subregions, such as the spacing between the base and the emitter (connection regions) of the device, will increase again. The latter is incompatible with the object aimed at.

US patent application US 2005/0121748 A1 discloses a bipolar transistor having an extrinsic base with a silicide conductive layer therein.

Consequently it is the object of the invention to provide a semiconductor device with a bipolar transistor which does not exhibit the aforesaid problem and which is easy to manufacture, therefore, and nevertheless has excellent RF properties.

In order to achieve that object, a semiconductor device of the kind referred to in the introduction is characterized in that the base connection region comprises a further conductive region which is positioned between the base region and the conductive region of polycrystalline silicon and which is made of a material with respect to which the conductive region of polycrystalline silicon is selectively etchable.

The invention is in the first place based on the perception that if the base connection region comprises a further conductive region besides to said conductive region, with respect to which the conductive region is selectively etchable, a heat treatment is not necessary, because the presence of such a further conductive region at the location of the base connection region is not necessarily a drawback and may even be an important advantage. The invention is furthermore based on the perception that such a region structure and material properties at the location of the emitter connection region are also useful in forming the emitter connection region and the emitter region. An additional factor in this regard is that a short-circuit between the emitter (connection region) and the base (connection region) can easily be prevented, for example by using said spacer. This can be done by removing the conductive layer in the opening in the silicon layer before a spacer is provided against the wall of the opening and on a part of the bottom that joins said wall.

On the one hand a device according to the invention is thus very easy to manufacture and on the other hand excellent RF properties can be realised without difficulty.

In a preferred embodiment of a semiconductor device according to the invention, the material of said further conductive region is selectively etchable with respect to the material of the base region. On the one hand this allows a relatively great thickness of said further conductive region and on the other hand roughening of the semiconductor body under said further conductive region can easily be prevented.

In an advantageous embodiment, said further conductive region comprises a metal nitride, carbide, silicide or oxide. A suitable material having the desired properties can be found within said range of materials. A suitable material is TaN, for example, a material with respect to which polycrystalline silicon can easily be selectively etched. Other suitable materials are, for example, conductive materials which are also suitable for so-termed metallic gate electrodes in a CMOS (=Complementary Metal Oxide Semiconductor) device such as TiN, TaC and TiSi₂. An important advantage of a device according to the invention is that it may possess a base connection region having a lower contact and/or series resistance than a known device. This can be realised in part by paying attention to the operating function of the material of the further conductive layer. Materials that are suitable for this purpose may be PtSi and MoOₓ, for example.

When a metal silicide is used for said further conductive region, this may be formed advantageously by depositing a metal layer that can be converted into a metal silicide by reacting with an adjacent silicon region.

Preferably, the mesa-shaped emitter connection region has a T-shaped cross-section extending above an insulating region formed on top of the conductive region. Such a structure is very attractive because it enables the use of a very small emitter region whilst on the other hand a limited (series) resistance of the emitter connection region is possible. This has a positive effect as regards the RF properties.

In an advantageous variant, the base region comprises a highly doped subregion sunken in the semiconductor body, which, seen in projection, is adjacent to the outer side of the upper part of the emitter connection region. Since said further conductive region (as well as the conductive region) continues to (substantially) the base of the mesa-shaped emitter connection region, it is an additional advantage that an additional local increase of the doping in the base region can be carried out with the mesa-shaped emitter connection region having a T-shaped cross-section as the mask in the case of an implantation. After all, since said further conductive region, for example in the form of a metal silicide, continues under the arms of a T-shaped mesa, the connection resistance of the base region can nevertheless be relatively low, in spite of the slightly larger distance between the implanted region and the base of the T-shaped mesa.

Preferably, the device comprises field effect transistors in addition to bipolar transistors, the gate electrode of which field effect transistors has been formed by means of a layer structure as used also for forming said conductive region of polycrystalline silicon and said further conductive region. RF circuits can advantageously be realised in such a Bi(C)MOS structure/process. In itself the structure of the base connection region in a device according to the invention means that it is quite compatible with a (C)MOS process. Application in a Bi(C)MOS process will be relatively easy in that case, of course. An additional advantage of a device according to the invention is that it may have a relatively thick base connection region, in which a (thinner) metal or metallic layer is covered with a relatively thick polycrystalline silicon layer. In this way the metal layer is protected fairly well, so that contamination of other components or parts of the device with the metal atoms forming part of the metal layer will not easily occur.

A method of manufacturing a semiconductor device with a substrate and a semiconductor body comprising a bipolar transistor with an emitter region of a first conductivity type, a base region of a second conductivity type opposite to the first conductivity type and a collector region of said first conductivity type, which emitter region is formed with a mesa-shaped emitter connection region, which is isolated from a base connection region made up of a conductive region of polycrystalline silicon by means of a spacer, is according to the invention characterized in that the base connection region is formed with a further conductive region which is formed between the base region and the conductive region of polycrystalline silicon and for which a material is selected with respect to which the conductive region is selectively etchable. In this way a device according to the invention is obtained in a simple manner.

Preferably, a material which is selectively etchable with respect to the material of the base region is selected for said further conductive region.

In an advantageous embodiment, the base region is formed at the surface of the semiconductor body and a conductive layer of polycrystalline silicon is deposited on a further conductive layer formed on the surface of the semiconductor body, after which an opening is etched in said conductive layer by means of an etchant that is selective to said further conductive layer. After the opening in the conductive layer has been formed, said further conductive layer is preferably etched therein by means of an etchant that is selective to the base region.

A further variant is characterized in that after the spacer has been formed against the walls of the opening and on a part of the bottom of the opening that joins said walls, an emitter connection region of polycrystalline silicon is formed in said opening. The actual emitter region is in that case preferably formed by outdiffusion of suitable atoms from the emitter connection region into a more lowly doped part of the base region positioned thereunder. The emitter region can also be formed via the bottom of the opening, however, for example by means of gas phase doping, and only then forming the emitter connection region.

Preferably, the emitter connection region is formed with a T-shaped cross-section and arranged to extend beside the opening above an insulating region present on top of the conductive region. The emitter connection region thus configured can be used as a mask for forming a more highly doped subregion of the base region by means of ion implantation.

The invention will now be explained in more detail with reference to an embodiment and the drawing, in which:

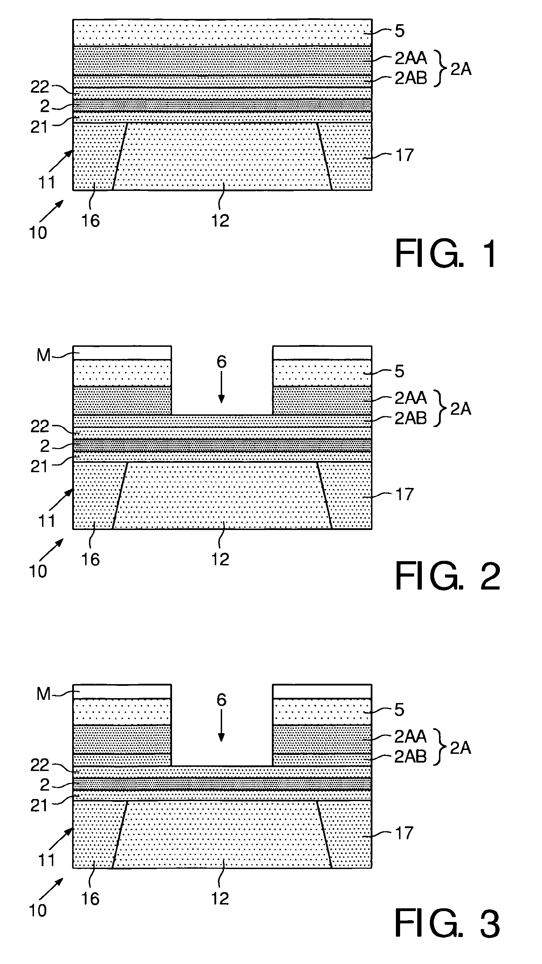

Figs. 1-6 are schematic, cross-sectional views perpendicular to the thickness direction of a device according to the invention, showing successive stages of the manufacture thereof by means of a method according to the invention.

The Figures are not drawn to scale, and some dimensions are exaggerated for the sake of clarity. Like regions or parts are indicated by the same numerals as much as possible.

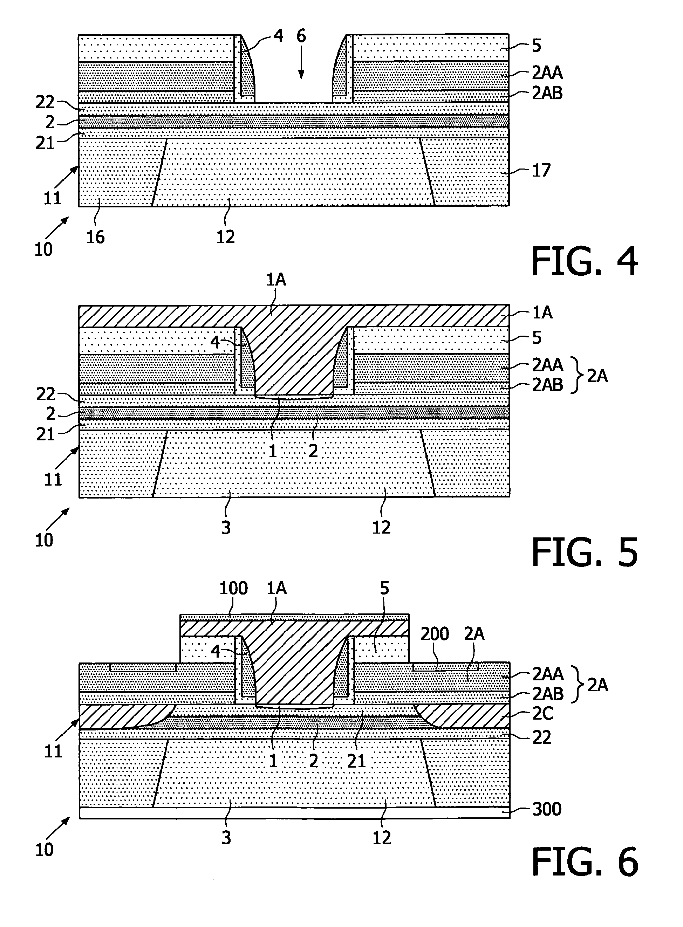

Figs. 1-6 are schematic, cross-sectional views perpendicular to the thickness direction of a device according to the invention, showing successive stages of the manufacture thereof by means of a method according to the invention. The - at least substantially complete - device 10 (see Fig. 6) of this example comprises a semiconductor body 11 with, in this case, an n-type silicon substrate 12 and a semiconductor layer structure provided thereon and a bipolar transistor. The discrete (in this example) transistor has an n-type emitter region 1, a p-type base region 2 and an n-type collector region 3, which are provided with a first, a second and a third connection conductor 100, 200, 300, respectively. The base region 2 comprises a mixed crystal of silicon and germanium having a germanium content of 20 at.% and, in this example, a doping concentration in the range of 1 x 10¹⁸ at/cm³ to 5 x 10¹⁹ at/cm³. Layered regions 21, 22 are positioned on either side of the base region, which regions function as transition layers and which have a lower doping concentration, for example in the range of 1 x 10¹⁷ at/cm³ to 1 x 10¹⁸ at/cm³. The emitter region 1 has been formed in the transition layer 22 by outdiffusion and overdoping. The collector 3 and the emitter 1 comprise silicon in this case. The collector 3 may furthermore (unlike the present example) be built up of a lowly doped part, the so-termed drift region, and a highly doped part that is positioned adjacent to the substrate. The connection conductors 100, 200 of the emitter region 1 and the base region 2 comprise a silicide in this case, for example nickel or cobalt silicide, whilst the connection conductor 300 of the collector region 3 comprises aluminium in this case. The emitter connection region 1A comprises a polycrystalline silicon region in this example, and is (electrically) isolated from the base connection region 2A by means of a spacer 4.

According to the invention, the base connection region 2A is built up of a polycrystalline silicon conductive region 2AA and, in addition to that, an underlying further conductive region, of tantalum nitride in this example, relative to which the polycrystalline silicon region 2AA can be selectively etched. The emitter connection region 1A is T-shaped (seen in cross-sectional view) in this example, with the arms of the T extending over an insulating region 5 present on top of the polycrystalline silicon region 2AA. Since said conductive region 2AA as well as said further conductive region 2AB extend as far as the spacer, the contact and series resistance of the electrical connection of the base 2 via the base connection region 2A is relatively low. The T-shaped mesa 1A has functioned as a mask for forming a more highly doped subregion 2c, which has been formed in the base region 2 by means of ion implantation. For the reason that has been discussed in the preceding sentence, the fact that said region 2C is spaced from the T-shaped mesa is not objectionable.

The lateral dimensions of the device 10 of this example are 1 µm x 10 µm. The emitter region 1 has a doping concentration of about 10²⁰ at/cm³ and a thickness of about 10 nm. The base region 2 has a thickness of about 20 nm, as have the adjacent transition layers 21, 22. The device 10 of this example is manufactured as follows, for example, by means of a method according to the invention.

The starting point (see Fig. 1) is an n-type silicon substrate 12, in which so-termed STI (=Shallow Trench Isolation) regions 16, 17 are formed in this example. An underlying part of the substrate 12 has been left out of the drawing for the sake of simplicity. P-type layers 21, 2 , 22 are first deposited thereon by epitaxy, with the centre layer being formed of SiGe and the outer two layers being formed of Si. Doping concentrations and thicknesses are selected as indicated above. Then a further layer structure is provided, for example in another deposition device, which structure comprises, successively, a conductive layer 2AB of tantalum nitride, a polycrystalline, highly doped silicon layer 2AA and an insulating layer 5 of silicon dioxide. Preferably, sputtering or MOCVD (=Metal Organic Chemical Vapor Depostion) is used as the deposition technique, for example for depositing the conductive layer 2AB in this example, whilst the polycrystalline silicon layer 2AA and the insulating layer are formed by CVD (=Chemical Vapour Deposition), with the thicknesses of said layer being 10 nm, 100 nm and 50 nm, respectively.

Subsequently (see Fig. 2) an opening 6 is etched in the insulating layer 5 and in the polycrystalline silicon layer 2AA, using a photolithographic mask M. This can be done by means of a dry etching process, for example. In said process, the tantalum nitride layer 2AB functions as an etch stop layer.

Following that (see Fig. 3), the tantalum nitride layer 2AB is selectively etched away with respect to the silicon layer 22 by means of a further etching process, for example a dry or a wet chemical etching process.

After removal of the mask M (see Fig. 4), the spacer 4 is formed in the opening 6, which spacers are built up, in this example, of two thin layers 41, 42 of silicon dioxide and silicon nitride having a thickness of 10 and 50 to 100 nm. The layers are uniformly applied and subsequently the flat portions thereof are removed by means of an anisotropic etching process.

Following this (see Fig. 5) the opening 6 is filled with an n-type polycrystalline silicon layer 1A. Said layer is formed by means of a CVD process. By subjecting the resulting structure to a heat treatment, an emitter region 1 is formed by local overdoping as a result of outdiffusion of the n-type contaminations in the emitter connection region 1A in the transition layer 22.

Then (see Fig. 6) the emitter connection region 1A is patterned by photolithography and etching whilst retaining the T-shaped cross-section. The width of the T at the base is about 200 nm, and the width of the T at the top is about 500 nm. Following this, the highly doped parts 2C of the base region 2 are formed by means of a p-type ion implantation, with the T-shaped connection region 1A functioning as a mask. It is noted that in practice a photoresist mask will still be present on the T-shaped mesa at that stage - contrary to what is shown in the drawing - and that in that case said implantation will take place between the manufacturing stages that are shown Fig. 5 and Fig. 6. On the one hand the photoresist mask protects the emitter connection region 1A against the implantation, and on the other hand the metal silicide layers 100, 200 can be formed in one step after removal of said mask.

Finally, the connection conductors 100, 200 are formed by depositing a metal layer of nickel or cobalt, which is converted into nickel or cobalt silicides 100, 200 by silicization. In this example, the rear side of the substrate 12 is contacted with aluminum, thus forming the connection conductor 300 of the collector region 3. The collector region 3 can also be contacted with the upper surface of the semiconductor body 11 via a connection region and a connection conductor. After a separating technique such as sawing or etching has been carried out, individual devices 10 according to the invention can be obtained.

In addition to being suitable for use in a discrete semiconductor device, the invention is also very suitable for use in an integrated semiconductor device, such as a (BI)CMOS (=(Bipolar) Complementary Metal Oxide Semiconductor) IC (= Integrated Circuit). In fact, the structure and the manufacture of the transistor as described in the examples is quite suitable for use in an IC.

Furthermore it is noted that instead of using STI isolation regions it is also possible to use further isolation regions that have been obtained by means of the LOCOS (= Local Oxidation Of Silicon) technique.

The invention is highly suitable for use in devices that comprise system silicon as the material.

## Claims

1. A semiconductor device (10) with a substrate (11) and a semiconductor body (11) comprising a bipolar transistor with an emitter region (1) of a first conductivity type, a base region (2) of a second conductivity type opposite to the first conductivity type and a collector region (3) of said first conductivity type, which emitter region (1) comprises a mesa-shaped emitter connection region (1A) provided with spacers (4) and adjacent thereto a base connection region (2A) comprising a conductive region (2AA) of polycrystalline silicon, **characterized in that** the base connection region (2A) comprises a further conducting region (2AB), which is positioned between the conductive region (2AA) of polycrystalline silicon and the base region (2) and which is made of a material with respect to which the conducting region (2AA) of polycrystalline silicon is selectively etchable.

2. A semiconductor device (10) as claimed in claim 1, **characterized in that** the material of said further conductive region (2AB) is selectively etchable with respect to the material of the base region (2).

3. A semiconductor device (10) as claimed in claim 1 or 2, **characterized in that** said further conductive region (2AB) comprises a metal nitride, carbide, silicide or oxide.

4. A semiconductor device (10) as claimed in claim 1, 2 or 3, **characterized in that** the mesa-shaped emitter connection region has a T-shaped cross-section extending above an insulating region (5) formed on top of the conductive region (2AA).

5. A semiconductor device (10) as claimed in any one of the preceding claims, **characterized in that** the base region (2) comprises a highly doped subregion (2C) sunken in the semiconductor body (11), which, seen in projection, is adjacent to the outer side of the upper part of the emitter connection region (1A).

6. A semiconductor device (10) as claimed in any one of the preceding claims, **characterized in that** the device comprises field effect transistors in addition to bipolar transistors, the gate electrode of which field effect transistors has been formed by means of a layer structure as used also for forming said conductive region (2AA) of polycrystalline silicon and said further conductive region (2AB).

7. A semiconductor device as claimed in any one of the preceding claims, **characterized in that** said transistor is a heterojunction transistor.

8. A method of manufacturing a semiconductor device (10) with a substrate (12) and a semiconductor body (11) comprising a bipolar transistor with an emitter region (1) of a first conductivity type, a base region (2) of a second conductivity type opposite to the first conductivity type and a collector region (3) of said first conductivity type, which emitter region (1) is formed with a mesa-shaped emitter connection region (1A), which is isolated from a base connection region (2A) made up of a conductive region (2AA) of polycrystalline silicon by means of a spacer (4), **characterized in that** the base connection region (2A) is formed with a further conductive region (2AB) which is formed between the base region (2) and the conductive region (2AA) of polycrystalline silicon and for which a material is selected with respect to which the conductive region (2AA) is selectively etchable.

9. A method as claimed in claim 8, **characterized in that** a material which is selectively etchable with respect to the material of the base region (2) is selected for said further conductive region (2AB).

10. A method as claimed in claim 8 or 9, **characterized in that** the base region (2) is formed at the surface of the semiconductor body (11) and **in that** a conductive layer (2AA) of polycrystalline silicon is deposited on a further conductive layer (2AB) formed on the surface of the semiconductor body (11), after which an opening (6) is etched in said conductive layer (2AA) by means of an etchant that is selective to said further conductive layer (2AB).

11. A method as claimed in claim 10, **characterized in that** after the opening (6) in the conductive layer (2AA) has been formed, said further conductive layer (2AB) is etched therein by means of an etchant that is selective to the base region (2).

12. A method as claimed in claim 11, **characterized in that** after the spacer (4) has been formed against the walls of the opening (6) and on a part of the bottom of the opening (6) that joins said walls, an emitter connection region (1A) of polycrystalline silicon is formed in said opening (6).

13. A method as claimed in claim 12, **characterized in that** the emitter connection region (1A) is formed with a T-shaped cross-section and arranged to extend beside the opening above an insulating region (5) present on top of the conductive layer (2AA).

14. A method as claimed in claim 13, **characterized in that** the base region (2) is provided with a more highly doped subregion (2C) which, seen in projection, is adjacent to the outer side of the emitter connection region (1A).

## Patentansprüche

1. Halbleitervorrichtung (10) mit einem Substrat (11) und einem Halbleiterkörper (11) aufweisend einen bipolaren Transistor mit einer Emitterregion (1) von einem ersten Leitfähigkeitstyp, eine Basisregion (2) von einem zweiten Leitfähigkeitstyp, welcher gegensätzlich zu dem ersten Leitfähigkeitstyp ist, und eine Kollektorregion (3) von dem ersten Leitfähigkeitstyp, welche Emitterregion (1) eine mesa-förmige Emitterverbindungsregion (1A), welche mit Spacem (4) bereitgestellt ist, und angrenzend dazu eine Basisverbindungsregion (2A) aufweisend eine leitende Region (2AA) aus polykristallinem Silizium aufweist,
**dadurch gekennzeichnet, dass**
die Basisverbindungsregion (2A) eine weitere leitende Region (2AB) aufweist, welche zwischen der leitenden Region (2AA) aus polykristallinem Silizium und der Basisregion (2) positioniert ist und welche aus einem Material hergestellt ist, bezüglich welchem die leitende Region (2AA) aus polykristallinem Silizium selektiv ätzbar ist.

2. Halbleitervorrichtung (10) wie in Anspruch 1 beansprucht, **dadurch gekennzeichnet, dass**
das Material der weiteren leitenden Region (2AB) selektiv ätzbar bezüglich des Materials der Basisregion (2) ist.

3. Halbleitervorrichtung (10) wie in Anspruch 1 oder 2 beansprucht, **dadurch gekennzeichnet, dass**
die weitere leitende Region (2AB) ein Metall-Nitrid, -Carbid, -Silicid oder -Oxid aufweist.

4. Halbleitervorrichtung (10) wie in Anspruch 1, 2 oder 3 beansprucht, **dadurch gekennzeichnet, dass**
die mesa-förmige Emitterverbindungsregion einen T-förmigen Querschnitt hat, welcher sich über eine Isolierungsregion (5), die auf der leitenden Region (2AA) gebildet ist, erstreckt.

5. Halbleitervorrichtung (10) wie in einem der vorangegangenen Ansprüche beansprucht, **dadurch gekennzeichnet, dass**
die Basisregion (2) eine hochdotierte Subregion (2C), die in dem Halbleiterkörper (11) versenkt ist, aufweist, welche, in einer Projektion gesehen, angrenzend zu der äußeren Seite des oberen Teils der Emitterverbindungsregion (1A) ist.

6. Halbleitervorrichtung (10), wie in einem der vorangegangenen Ansprüche beansprucht, **dadurch gekennzeichnet, dass**
die Vorrichtung zusätzlich zu bipolaren Transistoren Feldeffekttransistoren aufweist, wobei die Gate-Elektrode der Feldeffekttransistoren mittels einer Schichtstruktur gebildet ist, wie sie auch zur Bildung der leitenden Region (2AA) aus polykristallinem Silizium und der weiteren leitenden Region (2AB) verwendet wurde.

7. Halbleitervorrichtung (10) wie in einem der vorangegangenen Ansprüche beansprucht, **dadurch gekennzeichnet, dass**
der Transistor ein Heteroübergangstransistor ist.

8. Verfahren zum Herstellen einer Halbleitervorrichtung (10) mit einem Substrat (12) und einem Halbleiterkörper (11) aufweisend einen bipolaren Transistor mit einer Emitterregion (1) von einem ersten Leitfähigkeitstyp, einer Basisregion (2) von einem zweiten Leitfähigkeitstyp, welcher gegensätzlich zu dem ersten Leitfähigkeitstyp ist, und einer Kollektorregion (3) von dem ersten Leitfähigkeitstyp, welche Emitterregion (1) mit einer mesa-förmigen Emitterverbindungsregion (1A) gebildet wird, welche von einer Basisverbindungsregion (2A) bestehend aus einer leitenden Region (2AA) aus Polykristallinsilizium mittels eines Spacers (4) isoliert wird,
**dadurch gekennzeichnet, dass**
die Basisverbindungsregion (2A) mit einer weiteren leitenden Region (2AB) gebildet wird, welche zwischen der Basisregion (2) und der leitenden Region (2AA) aus polykristallinem Silizium gebildet ist und für welche ein Material ausgewählt wird, bezüglich welchem die leitende Region (2AA) selektiv ätzbar ist.

9. Verfahren wie in Anspruch 8 beansprucht, **dadurch gekennzeichnet, dass**
ein Material, welches selektiv ätzbar bezüglich dem Material der Basisregion (2) ist, für die weitere leitende Region (2AB) ausgewählt wird.

10. Verfahren wie in Anspruch 8 oder 9 beansprucht, **dadurch gekennzeichnet, dass**
die Basisregion (2) an der Oberfläche des Halbleiterkörpers (11) gebildet wird, und dass
eine leitende Schicht (2AA) aus polykristallinem Silizium auf einer weiteren leitenden Schicht (2AB) aufgebracht wird, welche auf der Oberfläche des Halbleiterkörpers (11) gebildet wird,
wobei danach eine Öffnung (6) in die leitende Schicht (2AA) mittels eines Ätzmittels, welches selektiv zu der weiteren leitenden Schicht (2AB) ist, geätzt wird.

11. Verfahren wie in Anspruch 10 beansprucht, **dadurch gekennzeichnet, dass**,
nachdem die Öffnung (6) in der leitenden Schicht (2AA) gebildet wurde, darin die weitere leitende Schicht (2AB) mittels eines Ätzmittels, welches selektiv zu der Basisregion (2) ist, geätzt wird.

12. Verfahren wie in Anspruch 11 beansprucht, **dadurch gekennzeichnet, dass**,
nachdem der Spacer (4) an der Wand der Öffnung (6) und auf einem Teil des Bodens der Öffnung (6), welcher an den Wänden angrenzt, gebildet wurde, eine Emitterverbindungsregion (1A) aus polykristallinem Silizium in der Öffnung (6) gebildet wird.

13. Verfahren wie in Anspruch 12 beansprucht, **dadurch gekennzeichnet, dass**
die Emitterverbindungsregion (1A) mit einem T-förmigen Querschnitt gebildet wird und angeordnet wird, um sich neben der Öffnung über einer Isolierungsregion (5), welche auf der leitenden Schicht (2AA) vorhanden ist, zu erstrecken.

14. Verfahren wie in Anspruch 13 beansprucht, **dadurch gekennzeichnet, dass**
die Basisregion (2) mit einer höher dotierten Subregion (2C) bereitgestellt ist, welche, in Projektion gesehen, an die äußere Seite der Emitterverbindungsregion (1A) angrenzt.

## Revendications

1. Dispositif à semi-conducteurs (10) avec un substrat (12) et un corps de semi-conducteurs (11) comprenant un transistor bipolaire avec une région d'émetteur (1) d'un premier type de conductivité, une région de base (2) d'un deuxième type de conductivité opposé au premier type de conductivité et une région de collecteur (3) dudit premier type de conductivité, laquelle région d'émetteur (1) comporte une région de connexion d'émetteur en forme de mesa (1A) munie d'espaceurs (4) et, adjacente à celle-là, une région de connexion de base (2A) comportant une région conductrice (2AA) de silicium poly-cristallin, **caractérisé par le fait que** la région de connexion de base (2A) comporte une autre région conductrice (2AB), qui est positionnée entre la région conductrice (2AA) de silicium poly-cristallin et la région de base (2) et qui est réalisée dans un matériau qui peut être gravé de manière sélective par rapport à la région conductrice (2AA) de silicium poly-cristallin.

2. Dispositif à semi-conducteurs (10) selon la revendication 1, **caractérisé par le fait que** le matériau de ladite autre région conductrice (2AB) peut être gravé de manière sélective par rapport au matériau de la région de base (2).

3. Dispositif à semi-conducteurs (10) selon les revendications 1 ou 2, **caractérisé par le fait que** ladite autre région conductrice (2AB) comporte un nitrure, un carbure, un siliciure ou un oxyde métallique.

4. Dispositif à semi-conducteurs (10) selon les revendications 1, 2 ou 3, **caractérisé par le fait que** la région de connexion d'émetteur en forme de mesa a une section en T s'étendant au-dessus d'une région isolante (5) formée au-dessus de la région conductrice (2AA).

5. Dispositif à semi-conducteurs (10) selon l'une quelconque des revendications précédentes, **caractérisé par le fait que** la région de base (2) comporte une sous-région fortement dopée (2C) enterrée dans le corps de semi-conducteur (11), qui, vue en projection, est adjacente à la face extérieure de la partie supérieure de la région de connexion d'émetteur (1A).

6. Dispositif à semi-conducteurs (10) selon l'une quelconque des revendications précédentes, **caractérisé par le fait que** le dispositif comporte des transistors à effet de champ en plus des transistors bipolaires, l'électrode de grille desquels transistors à effet de champ a été formée au moyen d'une structure de couche telle que celle également utilisée pour former lesdites régions conductrices (2AA) de silicium poly-cristallin et ladite autre région conductrices (2AB).

7. Dispositif à semi-conducteurs (10) selon l'une quelconque des revendications précédentes, **caractérisé par le fait que** ledit transistor est un transistor à hétérojonction.

8. Procédé de fabrication d'un dispositif à semi-conducteurs (10) avec un substrat (12) et un corps de semi-conducteurs (11) comprenant un transistor bipolaire avec une région d'émetteur (1) d'un premier type de conductivité, une région de base (2) d'un deuxième type de conductivité opposé au premier type de conductivité et une région de collecteur (3) dudit premier type de conductivité, laquelle région d'émetteur (1) est formée avec une région de connexion d'émetteur en forme de mesa (1A), qui est isolée, à l'aide d'un espaceur (4), d'une région de connexion de base (2A) constituée d'une région conductrice (2AA) de silicium poly-cristallin, **caractérisé par le fait que** la région de connexion de base (2A) est formée avec une autre région conductrice (2AB), qui est formée entre la région de base (2) et la région conductrice (2AA) de silicium poly-cristallin et pour laquelle est choisi un matériau qui peut être gravé de manière sélective par rapport à la région conductrice (2AA) de silicium poly-cristallin.

9. Procédé selon la revendication 8, **caractérisé par le fait que** le matériau qui peut être gravé de manière sélective par rapport au matériau de la région de base (2) est choisi pour ladite autre région conductrice (2AB).

10. Procédé selon les revendications 8 ou 9, **caractérisé par le fait que** la région de base (2) est formée sur la surface du corps de semi-conducteur (11) et qu'une surface conductrice (2AA) de silicium poly-cristallin est déposée sur une autre couche conductrice (2AB) formée sur la surface du corps de semi-conducteurs (11), après quoi une ouverture (6) est gravée dans ladite couche conductrice (2AA) avec un produit de gravure qui est sélectif par rapport à ladite couche conductrice (2AB).

11. Procédé selon la revendication 10, **caractérisé par le fait qu'**une fois formée l'ouverture (6) dans la couche conductrice (2AA), ladite autre couche conductrice (2AB) y est gravée à l'aide d'un produit de gravure qui est sélectif par rapport à la région de base (2).

12. Procédé selon la revendication 11, **caractérisé par le fait qu'**une fois que l'espaceur (4) a été formé contre les parois de l'ouverture (6) et sur une partie du fond de l'ouverture (6) qui jouxte lesdites parois, une région de connexion d'émetteur (1A) de silicium poly-cristallin est formée dans ladite ouverture (6).

13. Procédé selon la revendication 12, **caractérisé par le fait que** la région de connexion d'émetteur (1A) est formée avec une section en T et disposée de manière à s'étendre à côté de l'ouverture au-dessus d'une région isolante (5) présente au-dessus de la région conductrice (2AA).

14. Procédé selon la revendication 13, **caractérisé par le fait que** la région de base (2) est munie d'une sous-région plus fortement dopée (2C), qui, vue en projection, est adjacente à la face extérieure de la partie supérieure de la région de connexion d'émetteur (1A).
